# EUROPÄISCHE PATENTSCHRIFT

(11) **EP 2 130 238 B1**
(45) Veröffentlichungstag und Bekanntmachung des Hinweises auf die Patenterteilung: **11.04.2012**
(21) Anmeldenummer: 08716979.3
(22) Anmeldetag: 20.02.2008
(51) Int. Cl.: H01L 41/107

(54) **TRANSFORMATORANORDNUNG MIT EINEM PIEZOELEKTRISCHEN TRANSFORMATOR**
TRANSFORMER ARRANGEMENT HAVING A PIEZOELECTRIC TRANSFORMER
ENSEMBLE TRANSFORMATEUR COMPORTANT UN TRANSFORMATEUR PIÉZO-ÉLECTRIQUE

(30) Priorität: 26.02.2007 DE 102007009230
(43) Veröffentlichungstag der Anmeldung: 09.12.2009
(73) Patentinhaber: Epcos AG, 81669 München (DE)
(72) Erfinder: HOFFMANN, Christian, Dr., 8530 Deutschlandsberg (AT); KARTASHEV, Igor, Dr., 8530 Deutschlandsberg (AT); SCHMIDT-WINKEL, Patrick, Dr., 65510 Hünstetten (DE)
(74) Vertreter: Epping - Hermann - Fischer
(86) Internationale Anmeldenummer: PCT/EP2008/052070
(87) Internationale Veröffentlichungsnummer: WO 2008/104489

(56) Entgegenhaltungen:
- EP-A- 0 898 313
- US-A- 5 583 829

## Beschreibung

Ein mit Dickenschwingungen arbeitender piezoelektrischer Transformator ist aus der Druckschrift US 6,346,764 B1 be-_ kannt. Ein weiteres Beispiel für einen auf einem Träger befestigten piezoelektrischen Transformator ist aus EP898313 bekannt.

Eine zu lösende Aufgabe besteht darin, einen mit Dickenschwingungen arbeitenden piezoelektrischen Transformator anzugeben, der sich durch geringe Verluste, die durch parasitäre Schwingungsmoden verursacht werden, auszeichnet.

Es wird eine Transformatoranordnung mit einem piezoelektrischen Transformator und einem Träger angegeben. Der Transformator weist einen Körper in Form einer Platte auf, die sich parallel zu einer Hauptfläche der Platte erstrecken. Der Transformator arbeitet mit Dickenschwingungen. Der Körper ist in mindestens einem umlaufenden Bereich, in dem Wellenbäuche einer horizontalen Schwingung des Körpers auftreten, mit dem Träger fest verbunden.

Die Wellenbäuche kommen in den Bereichen zustande, in denen die minimale mechanische Spannung und die maximale Schwingungsamplitude auftreten. Die Wellenknoten kommen in den Bereichen zustande, in denen die maximale mechanische Spannung und die minimale Schwingungsamplitude auftreten.

Durch die in der angegebenen Transformatoranordnung absichtlich realisierte Fehlanpassung des akustischen Widerstands für die jeweilige parasitäre horizontale Schwingungsmode gelingt es, diese Mode gezielt zu unterdrücken.

Eine Auslenkung des Körpers erfolgt, wenn an den Eingangsteil des Transformators eine Spannung angelegt wird. Unter der Auslenkung versteht man eine Kontraktion oder Delatation des Körpers. Im Prinzip können dabei Dickenschwingungen, horizontale Schwingungen und Biegeschwingungen auftreten. Bei Dickenschwingung tritt eine vertikale Auslenkung des Körpers auf. Bei horizontaler Schwingung tritt eine Auslenkung des Körpers in Radialrichtung auf. Daher werden sie auch als Radialschwingungen bezeichnet.

Der piezoelektrische Transformator ist vorzugsweise für Hochfrequenzanwendungen ausgelegt. Da die Dicke der Platte wesentlich kleiner ist als deren Länge, ist die Frequenz der Grundschwingung bei Dickenschwingungen höher als diejenige der Grundschwingung bei horizontalen Schwingungen. Eine höhere Harmonische der horizontalen Grundschwingung, z. B. die fünfte, siebte, neunte oder elfte Harmonische, kann annähernd bei der Frequenz der nützlichen Dickenschwingung liegen. Diese Harmonische der horizontalen Grundschwingung stellt eine parasitäre Schwingungsmode dar, die durch die angegebene Fixierung des Körpers am Träger gezielt gedämpft werden kann.

Der Körper weist piezoelektrische Schichten und Elektroden auf. Vorzugsweise sind piezoelektrische Schichten und Elektroden in alternierender Reihenfolge übereinander angeordnet. Als Material für die piezoelektrischen Schichten kommt insbesondere Keramik wie z. B. Bleizirkonattitanat oder weitere geeignete Keramikmaterialien in Betracht. Insbesondere können bleifreie Materialien verwendet werden.

Die Platte stellt vorzugsweise eine flache Scheibe dar. Der Durchmesser der Scheibe beträgt vorzugsweise mindestens das Fünffache ihrer Dicke. Die Platte kann aber auch eine rechteckige, insbesondere quadratische Grundform aufweisen. Alternativ kann die Grundform oval oder vieleckig sein. Bei rechteckiger oder mehreckiger Grundform sind die Ecken vorzugsweise abgeschnitten, abgeflacht oder abgerundet. Im Folgenden wird ohne Einschränkung der Allgemeinheit der scheibenförmige Körper beschrieben.

Der Körper ist in Verbindungsbereichen fest mit dem Träger verbunden. In einer vorteilhaften Variante sind mehrere umlaufende Bereiche und ein Mittelbereich der Hauptfläche des Körpers vorgesehen, die Verbindungsbereiche aufweisen.

Der umlaufende Randbereich der zum Träger gewandten Hauptfläche des Körpers ist mittels erster Verbindungselemente mit dem Träger fest verbunden. Die ersten Verbindungselemente sind vorzugsweise in Umlaufrichtung voneinander beabstandet. Die ersten Verbindungselemente sind in Umlaufrichtung vorzugsweise gleichmäßig verteilt.

Der Randbereich grenzt vorzugsweise an die Kante der Hauptfläche an. Die Breite des Randbereichs beträgt vorzugsweise maximal 0,5 mm, aber vorzugsweise nicht mehr als 5% der horizontalen Länge der Platte.

Der Körper ist gemäß einer Variante in mindestens einem umlaufenden, von der Kante der Hauptfläche beabstandeten Bereich der Hauptfläche, in dem Wellenbäuche der horizontalen Schwingung auftreten, mittels zweiter Verbindungselemente mit dem Träger fest verbunden. Die zweiten Verbindungselemente sind vorzugsweise in Umlaufrichtung voneinander beabstandet. Sie sind in Umlaufrichtung vorzugsweise gleichmäßig verteilt. Die Breite des umlaufenden Bereichs der Hauptfläche, der die zweiten Verbindungselemente aufweist, beträgt vorzugsweise maximal 0,5 mm, jedoch vorzugsweise nicht mehr als 5% der horizontalen Länge der Platte.

Vorzugsweise ist ein umlaufender Bereich vorgesehen, der frei von Verbindungselementen ist. Dieser Bereich ist zwischen dem Randbereich und dem die Verbindungselemente aufweisenden umlaufenden Bereich der Hauptfläche angeordnet.

Der Mittelbereich der zum Träger gewandten Hauptfläche des Körpers ist vorzugsweise mittels mindestens eines dritten Verbindungselements fest mit dem Träger verbunden. Die lineare Querschnittsgröße des im Mittelbereich der Hauptfläche befindlichen Verbindungselements beträgt vorzugsweise maximal 0,5 mm.

Vorzugsweise ist ein weiterer umlaufender Bereich vorgesehen, der frei von Verbindungselementen ist. Dieser Bereich ist zwischen dem Mittelbereich und dem die Verbindungselemente aufweisenden umlaufenden Bereich der Hauptfläche angeordnet.

Die Summe der Flächen von Verbindungsbereichen zwischen dem Träger und dem Körper beträgt vorzugsweise maximal 10%, in einer Variante maximal 5% der Hauptfläche des Körpers. Dadurch gelingt es, eine gute mechanische Entkopplung zwischen dem Transformator und dem Träger zu erzielen. Dies ist zur Vermeidung von Verlusten bei der Betriebsmode des Transformators vorteilhaft. Die Betriebsmode ist vorzugsweise identisch mit der ersten Harmonischen der Dickenschwingung. Alternativ kann eine höhere, z. B. die dritte Harmonische der Dickenschwingung, als Betriebsmode des Transformators vorgesehen sein.

Vorzugsweise sind für eine effiziente Unterdrückung der horizontalen Schwingung mindestens acht erste Verbindungselemente vorgesehen. Vorzugsweise sind mindestens vier zweite Verbindungselemente vorgesehen.

Vorzugsweise sind in der jeweiligen Radialrichtung zwei Verbindungselemente in gleichem Abstand von der Mitte der Hauptfläche angeordnet. Diese Verbindungselemente bilden ein Paar. In einer ausgewählten Radialrichtung kann mehr als ein Paar der Verbindungselemente angeordnet sein. Bevorzugt ist eine symmetrische Anordnung von Verbindungselementen.

In einem nicht befestigten Mittelbereich des Körpers würden maximale Auslenkungen durch Biegeschwingungen auftreten. Durch die Fixierung des Mittelbereichs am Träger gelingt es, Biegeschwingungen des Körpers zu dämpfen. Durch die Fixierung des Körpers im umlaufenden Bereich, der zwischen dem Randbereich und dem Mittelbereich angeordnet ist, können die Biegeschwingungen zusätzlich gedämpft werden.

Der piezoelektrische Transformator weist einen Eingangsteil und einen Ausgangsteil auf, die übereinander angeordnet sind. In einer Variante ist zwischen dem Eingangsteil und dem Ausgangsteil ein Isolationsbereich angeordnet. Der Isolationsbereich ist durch eine elektrisch isolierende Schicht gebildet, die sich in horizontaler Ebene parallel zur Hauptfläche des Körpers erstreckt. Der Eingangsteil und der Ausgangsteil sind durch den Isolationsbereich mechanisch miteinander verbunden und galvanisch voneinander getrennt.

Der Eingangsteil und der Ausgangsteil weisen jeweils mindestens eine Elektrode pro Polarität auf. Es können auch mindestens zwei leitend miteinander verbundene Elektroden pro Polarität vorgesehen sein. Der Eingangsteil und der Ausgangsteil weisen in einer Variante jeweils mindestens eine im Körper angeordnete Innenelektrode auf.

Der Eingangsteil weist vorzugsweise alternierend angeordnete Elektroden erster und zweiter Polarität auf. Der Ausgangsteil weist vorzugsweise alternierend angeordnete Elektroden dritter und vierter Polarität auf.

Der Eingangsteil und der Ausgangsteil bzw. ihre als Masseelektroden vorgesehenen Elektroden sind in einer Variante an eine gemeinsame Masse angeschlossen.

Mindestens eines der Verbindungselemente kann durch eine Lötverbindung oder Bump gebildet sein. Die jeweilige Lötverbindung verbindet eine Anschlussfläche des Transformators mit einer elektrischen Kontaktfläche des Trägers. Der Transformator ist dabei vorzugsweise in einer Flip-Chip-Anordnung auf dem Träger befestigt. Möglich ist aber auch, zumindest einige der Verbindungselemente aus einem elektrisch isolierenden, vorzugsweise steifen - d. h. nicht elastischen - Material zu wählen.

In einer Ausführungsform sind erste Elektroden des Eingangsteils durch mindestens eine im Körper angeordnete erste Durchkontaktierung leitend miteinander und einer Anschlussfläche verbunden. Zweite Elektroden des Eingangsteils sind durch mindestens eine im Körper angeordnete zweite Durchkontaktierung leitend miteinander und einer Anschlussfläche verbunden. Erste Elektroden des Ausgangsteils sind durch mindestens eine im Körper angeordnete dritte Durchkontaktierung leitend miteinander und einer Anschlussfläche verbunden. Zweite Elektroden des Ausgangsteils sind durch die mindestens eine zweite Durchkontaktierung oder mindestens eine im Körper angeordnete vierte Durchkontaktierung leitend miteinander und einer Anschlussfläche verbunden.

In einer Ausführungsform sind erste Elektroden des Eingangsteils durch mindestens eine an der Oberfläche des Körpers angeordnete erste Außenmetallisierung leitend miteinander und einer Anschlussfläche verbunden. Zweite Elektroden des Eingangsteils sind durch mindestens eine an der Oberfläche des Körpers angeordnete zweite Außenmetallisierung leitend miteinander und einer Anschlussfläche verbunden. Erste Elektroden des Ausgangsteils sind durch mindestens eine an der Oberfläche des Körpers angeordnete dritte Außenmetallisierung leitend miteinander und einer Anschlussfläche verbunden. Zweite Elektroden des Ausgangsteils sind durch die mindestens eine zweite Außenmetallisierung oder mindestens eine an der Oberfläche des Körpers angeordnete vierte Außenmetallisierung leitend miteinander und einer Anschlussfläche verbunden.

Die vom Träger abgewandte Oberseite des Transformators ist vorzugsweise frei schwingbar.

Im Folgenden wird das angegebene Bauelement und seine vorteilhaften Ausgestaltungen anhand von schematischen und nicht maßstabgetreuen Figuren erläutert. Es zeigen:
Figur 1 verschiedene Schwingungsmoden für Plattenschwingungen, die im Körper eines piezoelektrischen Transformators stattfinden;
Figuren 2, 3, 4 die Ansicht jeweils eines piezoelektrischen Transformators von unten;
Figuren 5, 6 die Ansicht jeweils eines piezoelektrischen Transformators mit als Bumps ausgebildeten Verbindungselementen;
Figuren 7A, 7B verschiedene Querschnitte einer Transformatoranordnung mit einem ersten piezoelektrischen Transformator, bei dem der Eingangsteil und der Ausgangsteil eine gemeinsame Masse haben;
Figuren 7C, 7D, 7E verschiedene Elektrodenebenen der Transformatoranordnung gemäß den Figuren 7A, 7B;
Figuren 8A, 8B verschiedene Querschnitte einer Transformatoranordnung mit einem zweiten piezoelektrischen Transformator, bei dem der Eingangsteil und der Ausgangsteil eine gemeinsame Masse haben;
Figuren 8C, 8D, 8E verschiedene Elektrodenebenen der Transformatoranordnung gemäß den Figuren 8A, 8B;
Figuren 9A, 9B verschiedene Querschnitte einer Transformatoranordnung mit einem ersten piezoelektrischen Transformator, bei dem der Eingangsteil und der Ausgangsteil galvanisch voneinander getrennt sind;
Figuren 9C, 9D, 9E, 9F verschiedene Elektrodenebenen der Transformatoranordnung gemäß den Figuren 9A, 9B;
Figuren 10A, 10B verschiedene Querschnitte einer Transformatoranordnung mit einem zweiten piezoelektrischen Transformator, bei dem der Eingangsteil und der Ausgangsteil galvanisch voneinander getrennt sind;
Figuren 10C, 10D, 10E, 10F verschiedene Elektrodenebenen der Transformatoranordnung gemäß den Figuren 10A, 10B;
Figuren 11A, 11B verschiedene Querschnitte einer Transformatoranordnung mit einem piezoelektrischen Transformator, bei dem die der jeweiligen Polarität zugeordneten Elektroden durch eine Außenmetallisierung leitend miteinander verbunden sind;
Figur 11C die Ansicht des Transformators gemäß den Figuren 11A, 11B von unten;
Figur 11D den Transformator gemäß den Figuren 11A, 11B in einer perspektivischen Ansicht;
Figur 12 im Querschnitt eine Transformatoranordnung mit einem piezoelektrischen Transformator, bei dem pro Polarität eine Elektrode vorgesehen ist.

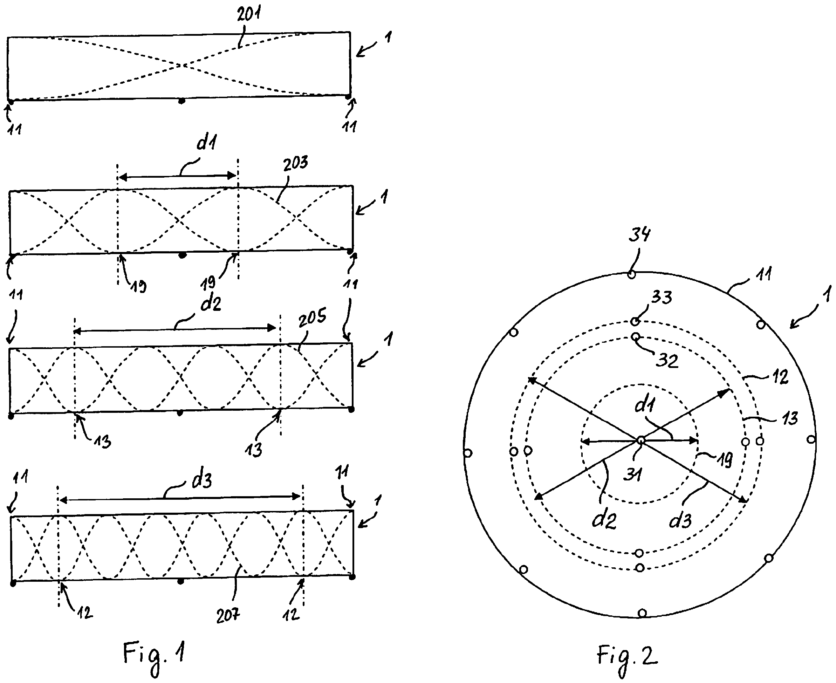

In der Figur 1 ist ein mit Dickenschwingungen arbeitender piezoelektrischer Transformator mit einem Körper 1 in einem Querschnitt gezeigt. Im Körper werden außerdem parasitäre horizontale Schwingungen angeregt.

In der Figur 1 ist mit gestrichelten Linien 201, 203, 205, 207 die Verteilung von Wellenknoten und -bäuchen für die erste, dritte, fünfte bzw. siebte Harmonische der horizontalen Grundschwingung angedeutet, wobei als erste Harmonische die Grundschwingung bezeichnet wird. Die Anzahl der Wellenknoten oder der Halbwellenlängen innerhalb des Körpers entspricht der Ordnung der Harmonischen. Dies gilt in analoger Weise auch für die höheren Harmonischen.

An Seitenflächen des Körpers, also auch im umlaufenden Randbereich 11 der Unterseite des Körpers, tritt stets ein Wellenbauch, d. h. ein Maximum der Auslenkungen auf. Außerdem treten Wellebäuche in weiteren umlaufenden Bereichen 12, 13, 19 auf. Im Bereich 19 treten Wellenbäuche der dritten Harmonischen, im Bereich 13 Wellenbäuche der fünften Harmonischen und im Bereich 12 Wellenbäuche der siebten Harmonischen auf.

Ein Bereich mit der gleichen Schwingungsphase stellt bei einem scheibenförmigen bzw. zylindrischen Körper einen Ring dar. Der Durchmesser d1 eines Bereichs, in dem die Wellenbäuche der dritten Harmonischen auftreten, beträgt ein Drittel der horizontalen Länge des Körpers 1. Der Durchmesser d2 eines Bereichs, in dem die Wellenbäuche der fünften Harmonischen auftreten, beträgt 3/5 der horizontalen Länge des Körpers 1. Der Durchmesser d3 eines Bereichs, in dem die Wellenbäuche der siebten Harmonischen auftreten, beträgt 5/7 der horizontalen Länge des Körpers 1.

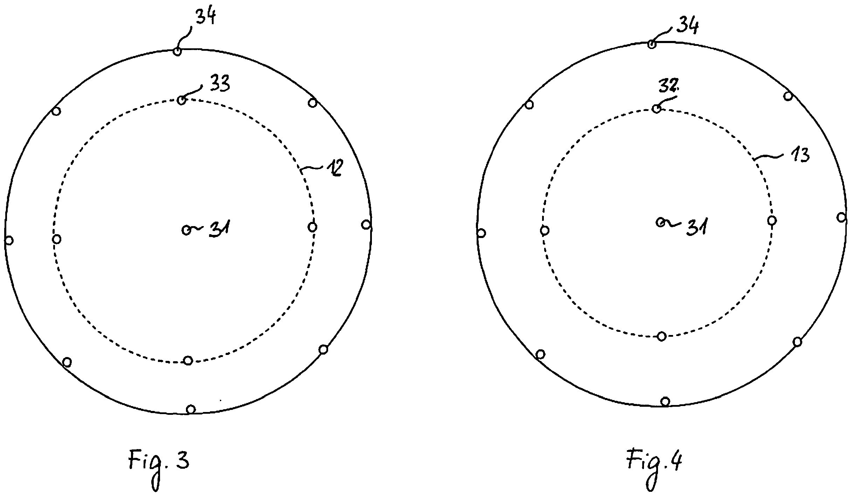

Bei höheren Moden gibt es mehrere konzentrische Wellenknotenbereiche, die um λ/2 voneinander beabstandet sind, sowie mehrere konzentrische Wellenbauchbereiche, die um λ/2 voneinander beabstandet sind, wobei λ eine auf die jeweilige Mode bezogene Wellenlänge ist. Im Prinzip kann die Befestigung des Körpers auf dem Träger 2 in einem beliebigen Wellenbauchbereich der zu dämpfenden Schwingungsmode erfolgen, vgl. Fig. 2, 3, 4. Der Träger 2 kann z. B. eine externe Leiterplatte oder ein Keramiksubstrat sein.

Bei der Befestigung des Körpers 1 wird die Kontaktfläche, d. h. die Querschnittsgröße der Verbindungselemente, vorzugsweise so klein wie möglich gewählt. Die Befestigung kann beispielsweise im Wesentlichen punktförmig erfolgen.

Der Randbereich 11 des Körpers ist durch mindestens acht erste Verbindungselemente 34 mit dem Träger 2 fest verbunden. In einer vorteilhaften Variante sind zwölf oder sechzehn erste Verbindungselemente 34, die in Umlaufrichtung in einem konstanten Abstand voneinander verteilt sind, vorgesehen. Vorzugsweise ist mindestens ein weiterer umlaufender Wellenbauchbereich 12, 13, 19 durch mindestens vier zweite Verbindungselemente 33, 32, 35 mit dem Träger 2 verbunden, siehe Fig. 2, 3, 4, 5. Die Breite des jeweiligen Bereichs 11, 12, 13, 19 ist gering und beträgt vorzugsweise maximal 0,5 mm.

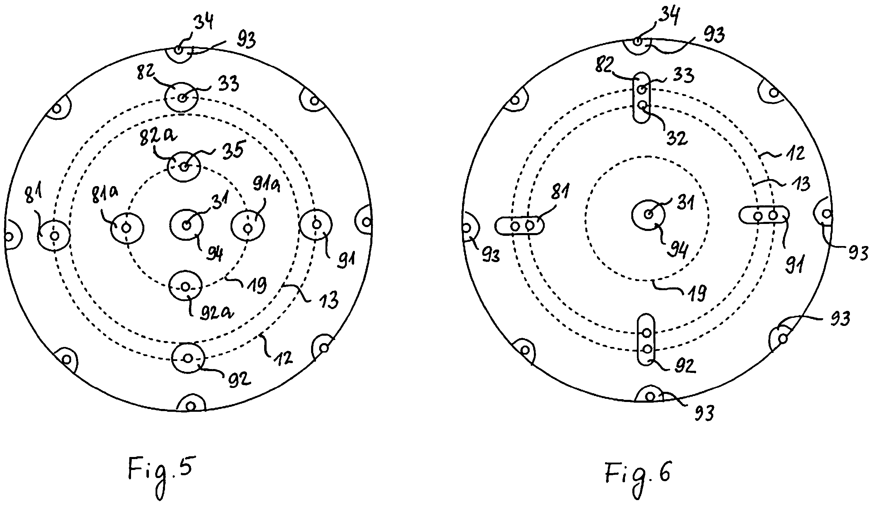

Die Verbindungselemente 33 liegen in Umlaufrichtung in Abstand voneinander auf der Linie 12, die Verbindungselemente 32 auf der Linie 13 und die Verbindungselemente 35 in Fig. 5 auf der Linie 19.

Durch die Anordnung von Verbindungselementen 32 in Umlaufrichtung gelingt es, die fünfte Harmonische der Radialschwingung zu dämpfen. Durch die Anordnung von Verbindungselementen 33 in Umlaufrichtung gelingt es, die siebte Harmonische der Radialschwingung zu dämpfen. Durch die Anordnung von Verbindungselementen 35 in Umlaufrichtung gelingt es, die dritte Harmonische der Radialschwingung zu dämpfen.

Zur Dämpfung der Biegeschwingung des Körpers wird der Mittelbereich der Unterseite des Körpers mittels des Befestigungselements 31 mit dem Träger 2 verbunden. Auch die Befestigung in den umlaufenden Bereichen 12, 13, 19, die zwischen der Mitte und dem Randbereich 11 angeordnet sind, ist im Sinne der Dämpfung der Biegeschwingungen wirksam.

Die Verbindungselemente, die eine elektrische Leitfähigkeit aufweisen, können zur elektrischen Kontaktierung des piezoelektrischen Transformators verwendet werden. Die Verbindungselemente können insbesondere als Bumps mit einer linearen Querschnittsgröße von maximal 300 Mikrometern ausgebildet sein. Die Bumps verbinden die auf der Unterseite des Körpers 1 angeordneten Anschlussflächen 81, 82, 91, 92 des Transformators mit den Kontaktflächen 10 des Trägers 2.

Im Körper 1 sind ein Eingangsteil 101 und ein Ausgangsteil 102 des Transformators realisiert. In den gezeigten Varianten ist der Eingangsteil 101 über dem Ausgangsteil 102 angeordnet. Die Ein- und Ausgangsteile können auch in allen Varianten gegeneinander ausgetauscht werden.

Die Anschlussflächen 81, 82 sind dem Eingangsteil 101 und die Anschlussflächen 91, 92 dem Ausgangsteil 102 des Transformators zugewiesen. Die Anschlussflächen 82 und 92 sind vorzugsweise zur Verbindung mit dem jeweiligen Bezugspotential vorgesehen.

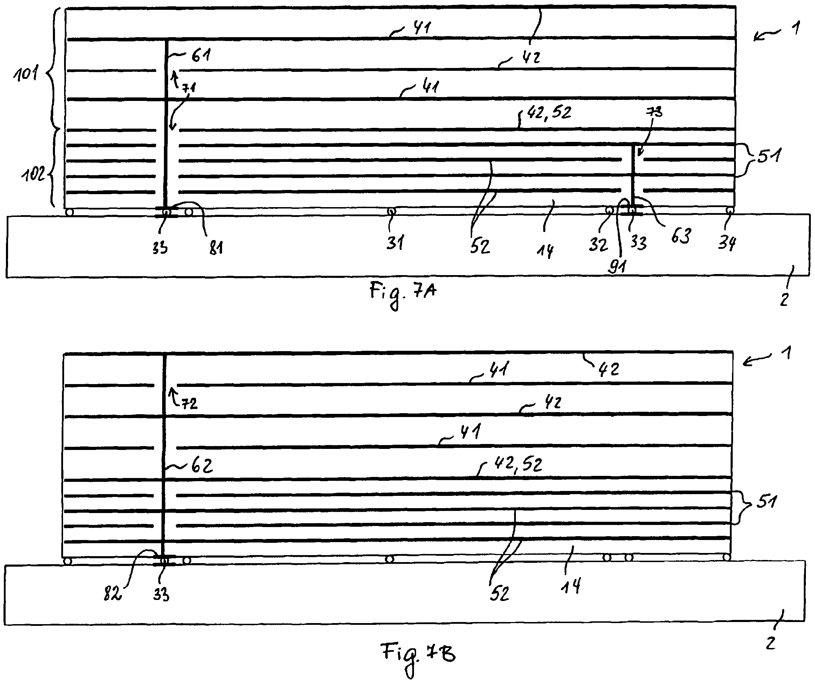

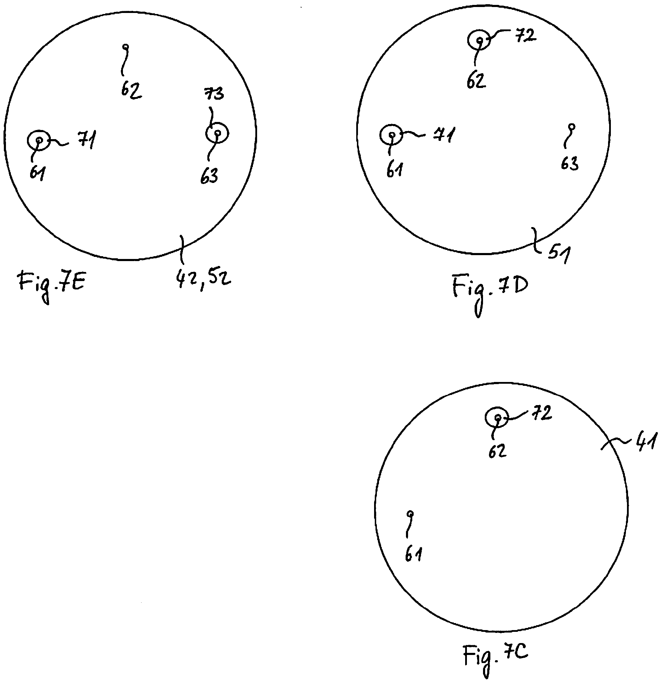

Auf der Unterseite des Körpers können auch zusätzliche leitende Flächen 93, 94, 95 vorgesehen sein, die als Unterlegflächen oder Under-Bump Metallization für die Verbindungselemente 31, 34 vorgesehen sind, siehe Figuren 7A, 8A, 9A, 10A und 11A. Zumindest einige dieser Flächen, wie z. B. die Unterlegflächen 93, 94 und 95, sind nicht mit den Elektroden des Transformators verbunden.

Die Unterlegflächen 81a, 82a, 91a, 92a in der Variante gemäß der Figur 5 sind dagegen mit den Elektroden des Transformators leitend verbunden und können im Prinzip als zusätzliche Anschlussflächen verwendet werden. Die jeweilige Unterlegfläche 81a, 82a, 91a, 92a ist in Fig. 5 von der leitend mit ihr verbundenen Anschlussfläche 81, 82, 91, 92 beabstandet. In diesem Fall ist nur ein Verbindungselement pro Unterlegfläche 81, 81a, 82, 82a, 91, 91a, 92, 92a, 93, 94 vorgesehen.

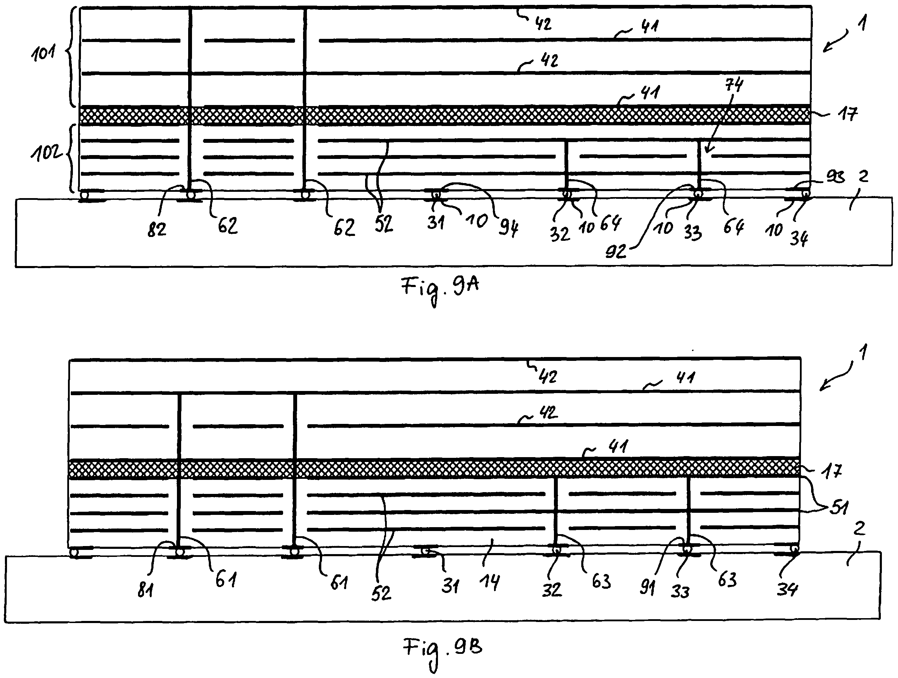

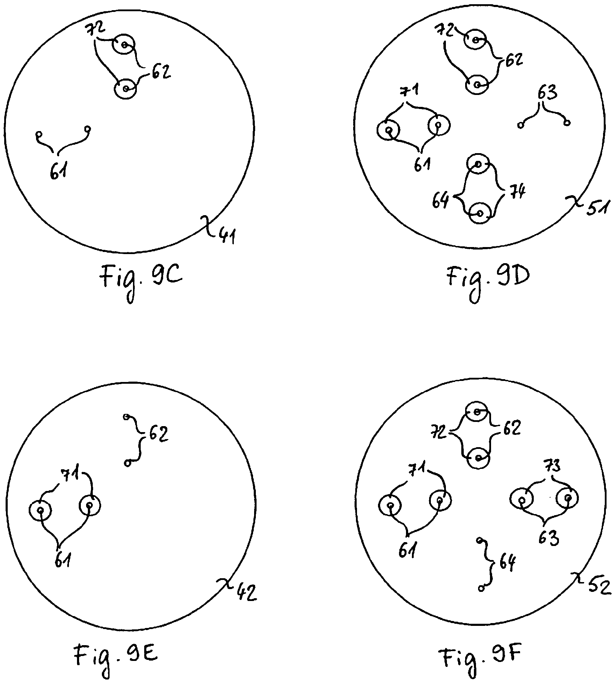

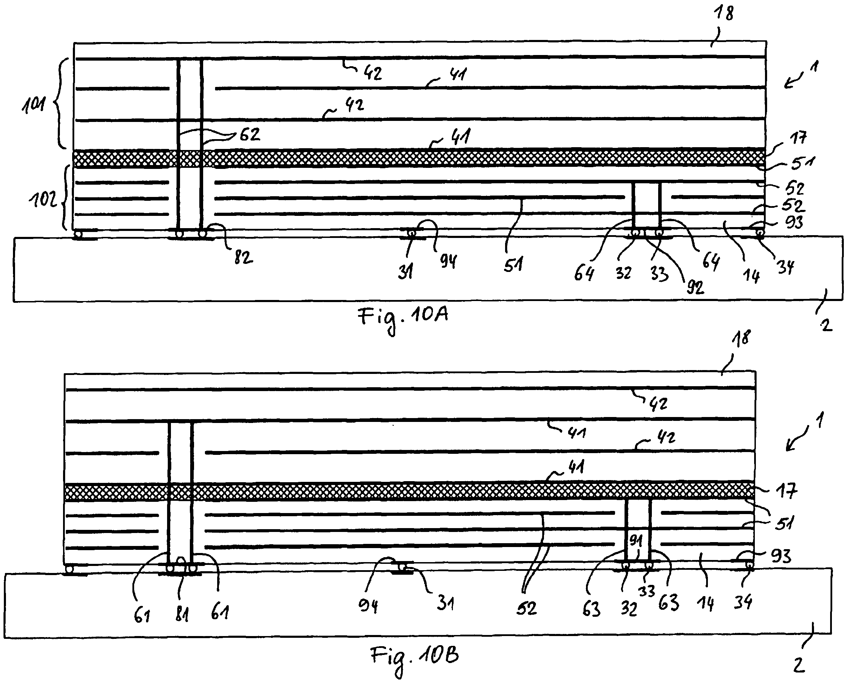

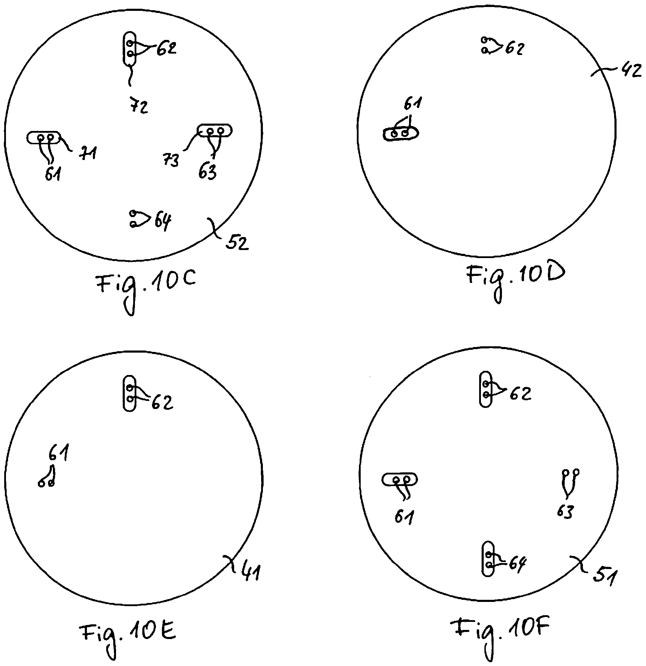

Es können aber auch mindestens zwei Verbindungselemente pro Unterlegfläche vorgesehen sein. In Fig. 6 sind dies jeweils zwei Verbindungselemente 32 und 33 pro Unterlegfläche 81, 82, 91, 92. Die Figur 5 entspricht der in der Figur 9A, 9B gezeigten Transformatoranordnung. Die Figur 6 entspricht der in der Figur 10A, 10B gezeigten Transformatoranordnung.

In der in Figuren 7A bis 7E gezeigten Ausführungsform sind im Körper 1 mehrere erste Elektroden 41 und mehrere zweite Elektroden 42 des Eingangsteils 101 sowie mehrere erste Elektroden 51 und mehrere zweite Elektroden 52 des Ausgangsteils 102 vorgesehen.

Die ersten Elektroden 41 des Eingangsteils sind mittels einer ersten Durchkontaktierung 61 leitend miteinander verbunden. Die zweiten Elektroden 42, 52 des Eingangsteils und des Ausgangsteils sind mittels einer zweiten Durchkontaktierung 62 leitend miteinander verbunden. Die ersten Elektroden 51 des Ausgangsteils sind mittels einer dritten Durchkontaktierung 63 leitend miteinander verbunden.

Die Durchkontaktierung 61 ist in einer Aussparung 71 der von dieser Durchkontaktierung galvanisch zu trennenden Elektrode 42, 51, 52 angeordnet. Die Durchkontaktierung 62 ist in einer Aussparung 72 der von dieser Durchkontaktierung galvanisch zu trennenden Elektrode 41, 51 angeordnet. Die Durchkontaktierung 63 ist in einer Aussparung 73 der von dieser Durchkontaktierung galvanisch zu trennenden Elektrode 52 angeordnet. Die den voneinander unterschiedlichen Polaritäten zugewiesenen Elektroden 41, 42, 51, 52 sind im Eingangsteil bzw. Ausgangsteil in abwechselnder Reihenfolge übereinander angeordnet, wobei zwischen zwei aufeinander folgenden Elektroden eine piezoelektrische Schicht angeordnet ist. Zwischen der untersten Elektrode des Transformators und dem Träger 2 ist vorzugsweise eine elektrisch isolierende Schicht 14 angeordnet. Auf der obersten Elektrode des Transformators kann eine weitere elektrisch isolierende Schicht 18 angeordnet sein, siehe Fig. 9A, 10A, 11A.

Die isolierende Schicht 14 und/oder 18 kann eine Passivierungsschicht aus einem beliebigen dielektrischen Material wie z. B. Glas, Siliziumdioxid, organische Beschichtung oder Keramik sein. Insbesondere kann für die endständigen elektrisch isolierenden Schichten 14, 18 das gleiche Material wie für die piezoelektrischen Schichten des Körpers verwendet werden. Es gilt für alle Ausführungsformen, dass auf mindestens eine der isolierenden Schichten 14, 18 verzichtet werden kann. Alternativ können in allen Ausführungsformen beide Schichten 14, 18 oder nur eine dieser Schichten, vorzugsweise die untere Schicht 14, verwendet werden.

In der Variante gemäß den Figuren 7A bis 7E sind nur drei elektrische Anschlüsse des Transformators vorgesehen, da der Eingangsteil 101 und der Ausgangsteil 102 an die gleiche Masse angeschlossen sind. Die Anschlussflächen, Durchkontaktierungen und Verbindungselemente sind in diesem Fall vorzugsweise entlang Radiallinien angeordnet, die einen Winkel von 120° zueinander bilden.

In den Varianten mit vier Anschlussflächen sind die Anschlussflächen, Durchkontaktierungen und Verbindungselemente vorzugsweise entlang Radiallinien angeordnet, die einen Winkel von 90° zueinander bilden.

In der Variante gemäß den Figuren 7A bis 7E sind die Verbindungselemente 33 als Bumps vorgesehen, wohingegen die Verbindungselemente 31, 32 und 34 z. B. elektrisch isolierend oder anderweitig ausgeführt sind.

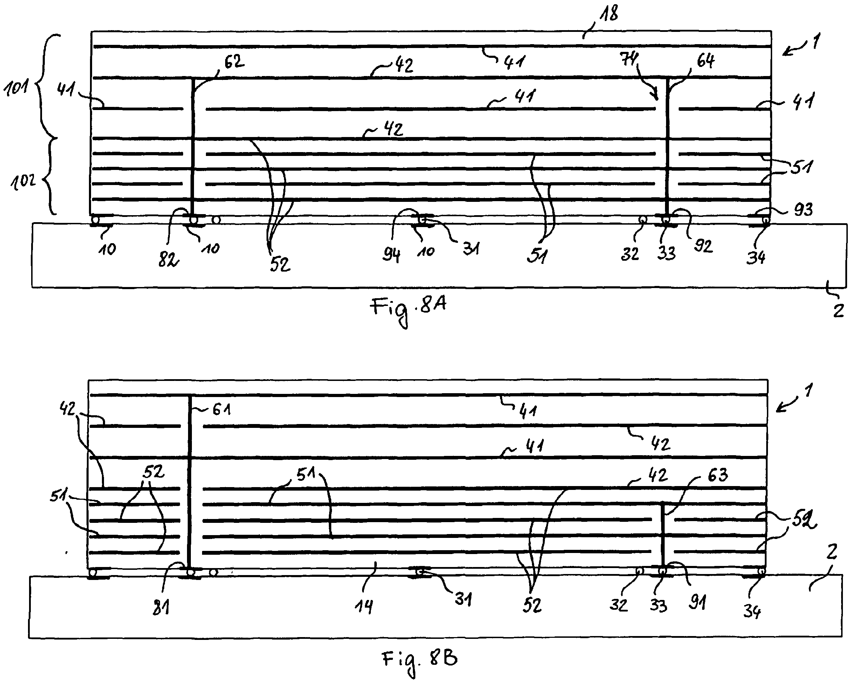

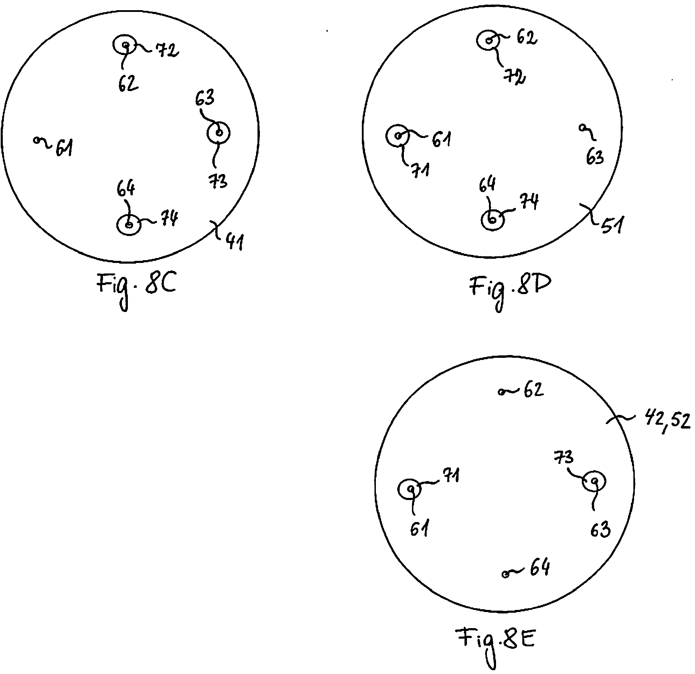

In der Variante gemäß den Figuren 8A bis 8E sind alle Verbindungselemente bis auf die Verbindungselemente 32 als Bumps ausgeführt. In diesem Fall sind die als Masseelektroden vorgesehenen Elektroden 42, 52 des Eingangsteil und des Ausgangsteils zusätzlich durch eine vierte Durchkontaktierung 64 miteinander verbunden. Die Durchkontaktierung 64 ist in einer Aussparung 74 der von dieser Durchkontaktierung galvanisch zu trennenden Elektroden 41, 51 angeordnet.

In der Variante gemäß den Figuren 9A bis 9F und 10A bis 10F sind die zweiten Elektroden 42 des Eingangsteils mittels zwei zweiten Durchkontaktierungen 62 und die zweiten Elektroden 52 des Ausgangsteils mittels zwei vierten Durchkontaktierungen 64 leitend miteinander verbunden. Die jeweilige Durchkontaktierung 64 ist in einer Aussparung 74 der von dieser Durchkontaktierung galvanisch zu trennenden Elektroden 51 angeordnet. Dies gilt in entsprechender Weise auch für die Verbindung der ersten Elektroden 41 des Eingangsteils mittels zwei Durchkontaktierungen 61 sowie für die Verbindung der ersten Elektroden 51 des Ausgangsteils mittels zwei Durchkontaktierungen 63. In der Variante gemäß Fig. 9A bis 9B ist für jede Aussparung eine Durchkontaktierung vorgesehen. In der Variante gemäß Fig. 10A bis 10B sind zwei Durchkontaktierungen in einer gemeinsamen Aussparung angeordnet.

Anstelle einer oder zwei Durchkontaktierungen können zur Verbindung der Elektroden der jeweiligen Polarität in allen Ausführungsformen mindestens drei Durchkontaktierungen vorgesehen sein. Sie können in einer gemeinsamen Aussparung oder in separaten Aussparungen angeordnet sein.

Zwischen dem Eingangsteil 101 und dem Ausgangsteil 102 ist in den Varianten gemäß den Figuren 9A, 9B und 10A, 10B zur galvanischen Trennung eine Isolationszone 17 angeordnet. Hier sind alle Verbindungselemente 31, 32, 33, 34 als Bumps ausgeführt. Als Bumps werden Lötverbindungen, die bei Flip-Chip-Technik entstehen, bezeichnet.

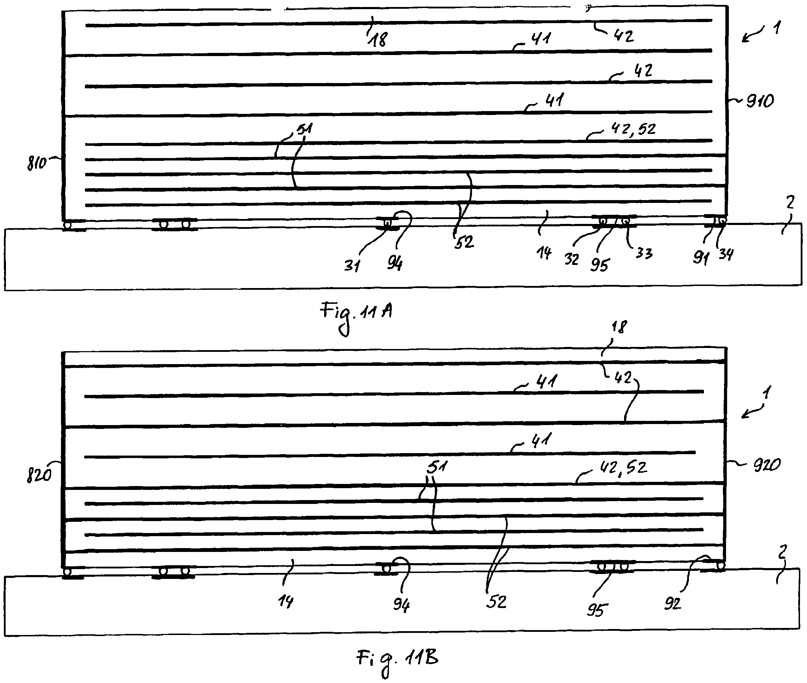

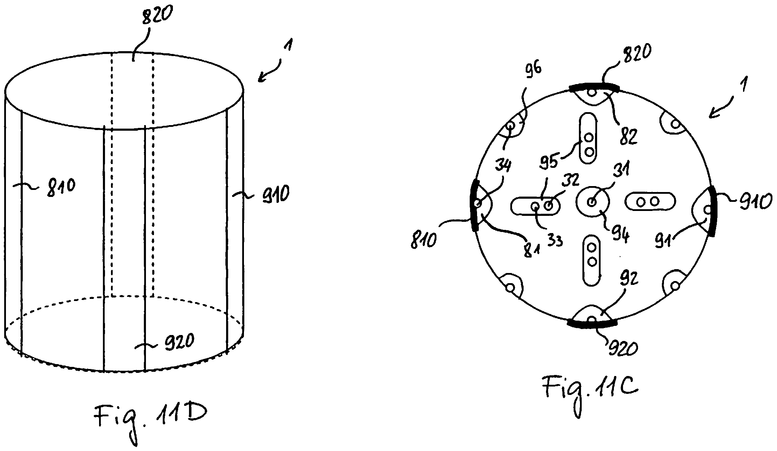

Die als Innenelektroden ausgeführten Elektroden 41, 42, 51, 52 können sich bis zur Seitenfläche des Körpers 1 erstrecken. Sie können aber auch von der Seitenfläche des Körpers 1 zurückgezogen sein. Dies gilt für alle Varianten und ist insbesondere in der Variante gemäß den Figuren 11A bis 11D sinnvoll, damit die Elektroden einer Polarität von der Außenmetallisierung der anderen Polarität getrennt werden.

In der Variante gemäß den Figuren 11A, 11B sind die ersten Elektroden 41 des Eingangsteils an die erste Außenmetallisierung 810, die ersten Elektroden 51 des Ausgangsteils an die dritte Außenmetallisierung 910 angeschlossen. Die zweiten Elektroden 42, 52 des Eingangsteils und des Ausgangsteils sind an die zweite Außenmetallisierung 820 sowie die vierte Außenmetallisierung 920 angeschlossen.

Möglich ist aber auch, die in den Figuren 11A, 11B gezeigte Ausführung mit galvanisch voneinander getrennten Ein- und Ausgangsteil des Transformators auszubilden. In diesem Fall sind die zweiten Elektroden 42 des Eingangsteils an die zweite Außenmetallisierung 820 angeschlossen und von der vierten Außenmetallisierung 920 galvanisch getrennt. Die zweiten Elektroden 52 des Ausgangsteils sind an die vierte Außenmetallisierung 920 angeschlossen und von der zweiten Außenmetallisierung 820 galvanisch getrennt.

Die erste Außenmetallisierung 810 ist an die erste Anschlussfläche 81, die zweite Außenmetallisierung 820 an die zweite Anschlussfläche 82, die dritte Außenmetallisierung 910 an die dritte Anschlussfläche 91 und die vierte Außenmetallisierung 920 an die vierte Anschlussfläche 92 angeschlossen. In diesem Fall sind die Anschlussflächen 81, 82, 91, 92 im Randbereich der Unterseite des Körpers angeordnet und durch einige der als Bumps ausgeführten ersten Verbindungselemente 34 mit dem Träger 2 verbunden. Die zweiten Verbindungselemente 32, 33 sind mit der jeweiligen Unterlegfläche 95 verbunden. Die ersten Verbindungselemente 34, die nicht mit den Anschlussflächen 81, 82, 91, 92 verbunden sind, sind mit weiteren Unterlegflächen 96 verbunden, die keine elektrische Verbindung zum Eingangsteil und Ausgangsteil des Transformators haben.

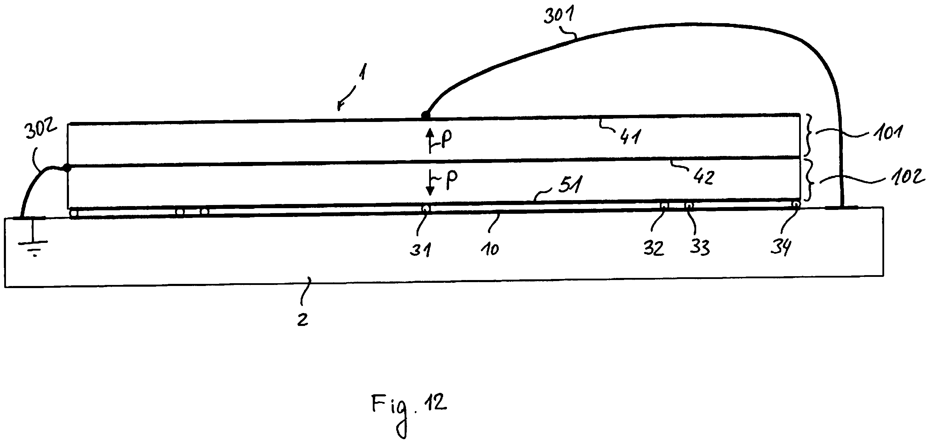

In der Figur 12 ist eine weitere Transformatoranordnung mit einem piezoelektrischen Transformator gezeigt. Der Eingangsteil 101 weist eine erste Elektrode 41 auf, die auf der Oberseite des Körpers angeordnet ist. Der Ausgangsteil 102 weist eine erste Elektrode 51 auf, die auf der Unterseite des Körpers angeordnet ist. Der Eingangsteil und der Ausgangsteil weisen eine gemeinsame Masseelektrode 42 auf.

Die Elektrode 41 ist mittels eines Drahtes 301 mit einer ersten Kontaktfläche des Trägers 2 leitend verbunden. Die Elektrode 51 ist mittels Bumps 31, 32, 33, 34 mit einer zweiten Kontaktfläche des Trägers 2 leitend verbunden. Die gemeinsame Masseelektrode 42 ist mittels eines Drahtes 302 mit einer dritten Kontaktfläche des Trägers 2 leitend verbunden.

Die untere Elektrode des Transformators ist bis auf die zur elektrischen Kontaktierung vorgesehenen, oberhalb der Bumps angeordneten Bereiche vorzugsweise passiviert. Die zweite Kontaktfläche 10 des Trägers 2 ist vorzugsweise auch in entsprechender Weise passiviert. Die zweite Kontaktfläche kann auch über nur einen Bump 31 oder einige der Bumps 31, 32, 33, 34 mit einer Anschlussfläche des Transformators verbunden werden. Für die Bumps 31, 32, 33, 34 können auch wie in den vorhergehenden Varianten getrennte Kontaktflächen vorgesehen sein.

Mit Pfeilen P ist die Polarisationsrichtung der jeweiligen piezoelektrischen Schicht des Transformators angedeutet.

Die angegebene Transformatoranordnung ist auf die in den Figuren erläuterten Ausführungsbeispiele, insbesondere die Form und die Anzahl der dargestellten Elemente, nicht beschränkt. Die Materialangaben sind nur als Beispiel genannt. Beliebige Unterlegflächen für die Bumps können als Anschlussflächen des Transformators benutzt werden.

Die Ausführungsmöglichkeiten sind auf einen scheibenförmigen Körper nicht beschränkt. Der Körper kann auch einen mehreckigen Querschnitt aufweisen. Der Körper kann die Form einer Platte oder eines vorzugsweise flachen Quaders aufweisen.

### Bezugszeichenliste

1 Körper des piezoelektrischen Transformators
10 Kontaktfläche
101 Eingangsteil
102 Ausgangsteil
11, 12, 13, 19 Bereich, in dem Wellenbäuche der horizontalen Schwingung auftreten
14 elektrisch isolierende Schicht
17 elektrisch isolierende Schicht
18 elektrisch isolierende Schicht
2 Träger
31, 32, 33, 34, 35 Verbindungselemente
d1 Abstand zwischen Wellenbäuchen der dritten Harmonischen
d2 Abstand zwischen Wellenbäuchen der fünften Harmonischen
d3 Abstand zwischen Wellenbäuchen der siebten Harmonischen
41 erste Elektroden des Eingangsteils
42 zweite Elektroden des Eingangsteils
51 erste Elektroden des Ausgangsteils
52 zweite Elektroden des Ausgangsteils
61, 62, 63, 64 Durchkontaktierungen
71, 72, 73, 74 Aussparungen
81, 81a, 82, 82a Anschlussflächen des Eingangsteils
91, 91a, 92, 92a Anschlussflächen des Ausgangsteils
93, 94, 95, 96 Unterlegflächen für die Bumps
810, 820, 910, 920 Außenmetallisierung
201 erste Harmonische der horizontalen Grundschwingung
203 dritte Harmonische der horizontalen Grundschwingung
205 fünfte Harmonische der horizontalen Grundschwingung
207 siebte Harmonische der horizontalen Grundschwingung
301, 302 Draht

## Patentansprüche

1. Transformatoranordnung
- mit einem piezoelektrischen Transformator und einem Träger (2),
- wobei der Transformator einen Körper (1) in Form einer Platte aufweist,
- wobei der Transformator mit Dickenschwingungen arbeitet,
- wobei der Körper (1) in mindestens einem umlaufenden Bereich (11, 12, 13, 19), in dem Wellenbäuche einer horizontalen Schwingung des Körpers (1) auftreten, mit dem Träger (2) fest verbunden ist.

2. Transformatoranordnung nach Anspruch 1,
- wobei ein umlaufender Randbereich (11) der zum Träger (2) gewandten Hauptfläche des Körpers (1) mittels erster Verbindungselemente (34) mit dem Träger (2) fest verbunden ist.

3. Transformatoranordnung nach einem der Ansprüche 1 oder 2,
- wobei der Körper (1) in mindestens einem umlaufenden, von der Kante des Körpers beabstandeten Bereich (12, 13, 19) der Hauptfläche, in dem Wellenbäuche der horizontalen Schwingung auftreten, mittels zweiter Verbindungselemente (32, 33, 35) mit dem Träger (2) fest verbunden ist.

4. Transformatoranordnung nach einem der Ansprüche 2 oder 3,
- wobei Verbindungselemente (32, 33, 34, 35) aus zumindest einer der Gruppen der ersten Verbindungselemente (34) und der zweiten Verbindungselemente (32, 33, 35) in Umlaufrichtung voneinander beabstandet sind.

5. Transformatoranordnung nach einem der Ansprüche 1 bis 4,
- wobei die Breite wenigstens eines des mindestens einen umlaufenden Bereichs (11, 12, 13, 19) maximal 0,5 mm beträgt.

6. Transformatoranordnung nach einem der Ansprüche 1 bis 5,
- wobei der Mittelbereich der zum Träger (2) gewandten Hauptfläche des Körpers (1) mittels mindestens eines dritten Verbindungselements (31) fest mit dem Träger (2) verbunden ist.

7. Transformatoranordnung nach Anspruch 3 bis 6,
- wobei wenigstens ein weiterer umlaufender Bereich, der zwischen dem Mittelbereich und dem die Verbindungselemente aufweisenden umlaufenden Bereich (13, 19) der Hauptfläche oder der zwischen dem Randbereich (11) und dem die Verbindungselemente aufweisenden umlaufenden Bereich (12) der Hauptfläche angeordnet ist, frei von Verbindungselementen (31, 32, 33, 34, 35) ist.

8. Transformatoranordnung nach einem der Ansprüche 1 bis 7,
- wobei die Summe der Flächen von Verbindungsbereichen zwischen dem Träger (2) und dem Körper (1) maximal 10% der Hauptfläche des Körpers beträgt.

9. Transformatoranordnung nach einem der Ansprüche 3 bis 8,
- wobei mindestens acht erste Verbindungselemente (34) vorgesehen sind,
- wobei mindestens vier zweite Verbindungselemente (32, 33, 35) vorgesehen sind.

10. Transformatoranordnung nach einem der Ansprüche 1 bis 9,
- wobei der piezoelektrische Transformator einen Eingangsteil (101) und einen Ausgangsteil (102) aufweist, die übereinander angeordnet sind.

11. Transformatoranordnung nach Anspruch 10,
- wobei der Eingangsteil (101) alternierend angeordnete Elektroden erster und zweiter Polarität (41, 42) aufweist,
- wobei der Ausgangsteil (102) alternierend angeordnete Elektroden dritter und vierter Polarität (51, 52) aufweist.

12. Transformatoranordnung nach einem der Ansprüche 2 bis 11,
- wobei mindestens eines der Verbindungselemente (31, 32, 33, 34, 35) durch eine Lötverbindung gebildet ist.

13. Transformatoranordnung nach Anspruch 12,
- wobei die jeweilige Lötverbindung eine Anschlussfläche (81, 82, 91, 92) des Transformators mit einer elektrischen Kontaktfläche (10) des Trägers (2) verbindet.

14. Transformatoranordnung nach einem der Ansprüche 11 bis 13,
- wobei die Elektroden (41, 42, 51, 52) der jeweiligen Polarität durch mindestens eine im Körper (1) angeordnete Durchkontaktierung (61, 62, 63, 64) leitend miteinander und der jeweiligen Anschlussfläche (81, 82, 91, 92) verbunden sind.

15. Transformatoranordnung nach einem der Ansprüche 11 bis 13,
- wobei die Elektroden (41, 42, 51, 52) der jeweiligen Polarität durch mindestens eine an der Oberfläche des Körpers (1) angeordnete Außenmetallisierung (810, 820, 910, 920) leitend miteinander und der jeweiligen Anschlussfläche (81, 82, 91, 92) verbunden sind.

## Claims

1. Transformer arrangement
- having a piezoelectric transformer and a mount (2), wherein the transformer has a body (1) in the form of a plate,
- wherein the transformer operates with thickness oscillations,
- wherein the body (1) is firmly connected to the mount (2) in at least one circumferential area (11, 12, 13, 19) in which wave antinodes of a horizontal oscillation of the body (1) occur.

2. Transformer arrangement according to Claim 1,
- wherein a circumferential edge area (11) of the main surface of the body (1), facing the mount (2), is firmly connected to the mount (2) by means of first connecting elements (34).

3. Transformer arrangement according to one of Claims 1 or 2,
- wherein the body (1) is firmly connected to the mount (2) by means of second connecting elements (32, 33, 35) in at least one circumferential area (12, 13, 19), which is at a distance from the edge of the body, of the main surface, in which wave antinodes of the horizontal oscillation occur.

4. Transformer arrangement according to one of Claims 2 or 3,
- wherein connecting elements (32, 33, 34, 35) from at least one of the groups of the first connecting elements (34) and of the second connecting elements (32, 33, 35) are separated from one another in the circumferential direction.

5. Transformer arrangement according to one of Claims 1 to 4,
- wherein the width of at least one of the at least one circumferential areas (11, 12, 13, 19) is a maximum of 0.5 mm.

6. Transformer arrangement according to one of Claims 1 to 5,
- wherein the central area of the main surface, facing the mount (2), of the body (1) is firmly connected to the mount (2) by means of at least one third connecting element (31).

7. Transformer arrangement according to Claims 3 to 6,
- wherein at least one further circumferential area is free of connecting elements (31, 32, 33, 34, 35), which further circumferential area is arranged between the central area and the circumferential area (13, 19) of the main surface which has the connecting elements or is arranged between the edge area (11) and the circumferential area (12) of the main surface which has the connecting elements.

8. Transformer arrangement according to one of Claims 1 to 7,
- wherein the sum of the areas of connecting areas between the mount (2) and the body (1) is at most 10% of the main surface area of the body.

9. Transformer arrangement according to one of Claims 3 to 8,
- wherein at least eight first connecting elements (34) are provided, and
- wherein at least four second connecting elements (32, 33, 35) are provided.

10. Transformer arrangement according to one of Claims 1 to 9,
- wherein the piezoelectric transformer has an input part (101) and an output part (102), which are arranged one above the other.

11. Transformer arrangement according to Claim 10.
- wherein the input part (101) has alternately arranged electrodes of first and second polarity (41, 42),
- wherein the output part (102) has alternately arranged electrodes of third and fourth polarity (51, 52).

12. Transformer arrangement according to one of Claims 2 to 11,
- wherein at least one of the connecting elements (31, 32, 33, 34, 35) is formed by a soldered joint.

13. Transformer arrangement according to Claim 12,
- wherein the respective soldered joint connects a connecting surface (81, 82, 91, 92) of the transformer to an electrical contact surface (10) of the mount (2).

14. Transformer arrangement according to one of Claims 11 to 13,
- wherein the electrodes (41, 42, 51, 52) of the respective polarity are conductively connected to one another and to the respective connecting surface (81, 82, 91, 92) by at least one through-plated contact (61, 62, 63, 64) which is arranged in the body (1).

15. Transformer arrangement according to one of Claims 11 to 13,
- wherein the electrodes (41, 42, 51, 52) of the respective polarity are conductively connected to one another and to the respective connecting surface (81, 82, 91, 92) via at least one external metallization (810, 820, 910, 920) which is arranged on the surface of the body (1).

## Revendications

1. Ensemble de transformateur présentant
un transformateur piézoélectrique et un support (2),
le transformateur présentant un corps (1) en forme de plaque,
le transformateur travaillant à partir d'oscillations d'épaisseur,
le corps (1) étant relié solidairement au support (2) dans au moins une partie périphérique (11, 12, 13, 19) dans laquelle surviennent les ventres d'une vibration horizontale du corps (1).

2. Ensemble de transformateur selon la revendication 1, dans lequel une bordure périphérique (11) de la surface principale du corps (1), tournée vers le support (2), est reliée solidairement au support (2) au moyen de premiers éléments de liaison (34).

3. Ensemble de transformateur selon l'une des revendications 1 ou 2, dans lequel des deuxièmes éléments de liaison (32, 33, 35) relient le corps (1) solidairement au support (2) dans au moins une partie périphérique (12, 13, 19) de la surface principale, située à distance du chant du corps et dans laquelle surviennent les ventres de vibration horizontale.

4. Ensemble de transformateur selon l'une des revendications 2 ou 3, dans lequel des éléments de liaison (32, 33, 34, 35) d'au moins l'un des groupes des premiers éléments de liaison (34) et des deuxièmes éléments de liaison (32, 33, 35) sont situés à distance les uns des autres dans la direction périphérique.

5. Ensemble de transformateur selon l'une des revendications 1 à 4, dans lequel la largeur d'au moins l'une des parties périphériques (11, 12, 13, 19) est d'au plus 0,5 mm.

6. Ensemble de transformateur selon l'une des revendications 1 à 5, dans lequel la partie centrale, tournée vers le support (2), de la surface de principale du corps (1) est reliée solidairement au support (2) au moyen d'au moins un troisième élément de liaison (31).

7. Ensemble de transformateur selon les revendications 3 à 6, dans lequel au moins une autre partie périphérique située entre la partie centrale et la partie périphérique (13, 19), tournée vers les éléments de liaison, de la surface principale ou située entre la bordure (11) et la partie périphérique (12), tournée vers les éléments de liaison, de la surface principale, ne présentent pas d'éléments de liaison (31, 32, 33, 34, 35).

8. Ensemble de transformateur selon l'une des revendications 1 à 7, dans lequel la somme des surfaces des parties de liaison entre le support (2) et le corps (1) représente au maximum 10 % de la surface principale du corps.

9. Ensemble de transformateur selon l'une des revendications 3 à 8, dans lequel au moins huit premiers éléments de liaison (34) sont prévus, au moins quatre deuxièmes éléments de liaison (32, 33, 35) étant prévus.

10. Ensemble de transformateur selon l'une des revendications 1 à 9, dans lequel le transformateur piézoélectrique présente une partie d'entrée (101) et une partie de sortie (102) disposées l'une au-dessus de l'autre.

11. Ensemble de transformateur selon la revendication 10, dans lequel la partie d'entrée (101) présente des électrodes alternées de première et de deuxième polarité (41, 42), la partie de sortie (102) présentant des électrodes alternées de troisième et de quatrième polarité (51, 52).

12. Ensemble de transformateur selon l'une des revendications 2 à 11, dans lequel au moins l'un des éléments de liaison (31, 32, 33, 34, 35) est formé par une liaison brasée.

13. Ensemble de transformateur selon la revendication 12, dans lequel les différentes liaisons brasées relient une surface de raccordement (81, 82, 91, 92) du transformateur à une surface (10) de contact électrique du support (2).

14. Ensemble de transformateur selon l'une des revendications 11 à 13, dans lequel les électrodes (41, 42, 51, 52) de chaque polarité sont reliées de manière conductrice les unes aux autres et à chaque surface de raccordement (81, 82, 91, 92) par une perforation de contact (61, 62, 63, 64) disposée dans le corps (1).

15. Ensemble de transformateur selon l'une des revendications 11 à 13, dans lequel les électrodes (41, 42, 51, 52) de chaque polarité sont reliées de manière conductrice les unes aux autres et à chaque surface de raccordement (81, 82, 91, 92) par au moins une métallisation extérieure (810, 820, 910, 920) disposée sur la surface du corps (1).
